# EUROPEAN PATENT APPLICATION

(11) **EP 4 593 536 A1**
(43) Date of publication of application: **30.07.2025**
(21) Application number: 23881286.1
(22) Date of filing: 28.06.2023
(51) Int. Cl.: H05K 1/02, H05K 3/46

(54) **LAYOUT SCHEME OF DATA TRANSMISSION WIRING, AND MAIN BOARD AND ELECTRONIC DEVICE**

(30) Priority: 25.10.2022 CN 202211312966
(71) Applicant: Huawei Technologies Co., Ltd., Shenzhen, Guangdong 518129 (CN)
(72) Inventor: XU, Longxiao, Shenzhen, Guangdong 518129 (CN); PENG, Xiangjie, Shenzhen, Guangdong 518129 (CN); JIANG, Zhe, Shenzhen, Guangdong 518129 (CN)
(74) Representative: Maiwald GmbH
(86) International application number: PCT/CN2023/103272
(87) International publication number: WO 2024/087697

(57) **Abstract**

A layout solution for data transmission trace, a mainboard, and an electronic device are disclosed. The data transmission trace includes first clock pair signal traces (20), first data pair signal traces (30), and a first matching trace (41). The first clock pair signal traces include a first clock signal trace (21) and a second clock signal trace (22), and the first clock pair signal traces are configured to transmit a clock signal. The first data pair signal traces include a first data signal trace (31) and a second data signal trace (32), and the first data pair signal traces are configured to transmit a data signal. The first clock pair signal traces are located between the first matching trace and the first data pair signal traces. The first clock signal trace and the second data signal trace are disposed adjacent to each other, and the second clock signal trace and the first matching trace are disposed adjacent to each other. A first inter-pair trace spacing between the first matching trace and the second clock signal trace is equal to a second inter-pair trace spacing between the second data signal trace and the first clock signal trace. This technical solution may resolve a problem of how to reduce electromagnetic interference in an electronic device.

## Description

This application claims priority to Chinese Patent Application No. 202211312966.X, filed with the China National Intellectual Property Administration on October 25, 2022 and entitled "LAYOUT SOLUTION FOR DATA TRANSMISSION TRACE, MAINBOARD, AND ELECTRONIC DEVICE", which is incorporated herein by reference in its entirety.

### TECHNICAL FIELD

This application relates to the field of data transmission technologies, and in particular, to a layout solution for data transmission trace, a mainboard, and an electronic device.

### BACKGROUND

With the development of the information world, a signal transmission rate is increasingly high, and video transmission interfaces with clock pairs, such as a high definition multimedia interface (high definition multimedia interface, HDMI), are widely used in electronic devices because of a relatively high audio/video transmission speed. However, the video transmission interfaces with clock pairs are prone to overrun electromagnetic interference (electromagnetic interference, EMI).

Overrun electromagnetic interference leads to electronic devices being classified as unqualified products. Therefore, how to reduce electromagnetic interference in an electronic device is a hot issue of constant concern.

### SUMMARY

Embodiments of this application provide a layout solution for data transmission trace, a mainboard, and an electronic device, to resolve a problem of how to reduce electromagnetic interference in an electronic device.

To achieve the foregoing objective, this application uses the following technical solutions.

According to a first aspect of embodiments of this application, a layout solution for data transmission trace is provided. The layout solution may be applied to, for example, a trace layout of a high definition multimedia interface. The data transmission trace includes first clock pair signal traces, first data pair signal traces, and a first matching trace. The first clock pair signal traces include a first clock signal trace and a second clock signal trace, and the first clock pair signal traces are configured to transmit a clock signal. The first data pair signal traces include a first data signal trace and a second data signal trace, and the first data pair signal traces are configured to transmit a data signal. In the layout solution for data transmission trace provided in this application, the first clock pair signal traces are located between the first matching trace and the first data pair signal traces. The first clock signal trace and the second data signal trace are disposed adjacent to each other, and the second clock signal trace and the first matching trace are disposed adjacent to each other. The first matching trace includes a matching segment, and a first inter-pair trace spacing between the matching segment and the second clock signal trace is equal to a second inter-pair trace spacing between the second data signal trace and the first clock signal trace.

In the layout solution for data transmission trace provided in this embodiment of this application, the first data pair signal traces are arranged on a first side of the first clock pair signal traces, and the first matching trace is arranged on an opposite second side of the first clock pair signal traces. Presence of the first matching trace may change a parasitic parameter (for example, a value of parasitic capacitance) on the second side of the first clock pair signal traces. The first inter-pair trace spacing between the matching segment and the second clock signal trace is enabled to be equal to the second inter-pair trace spacing between the second data signal trace and the first clock signal trace, so that consistency between parasitic parameters on the two sides of the first clock pair signal traces may be improved, to reduce differential-to-common mode conversion in the first clock pair signal traces, and improve an EMI suppression effect. In addition, in this embodiment of this application, EMI is reduced by improving the consistency between the parasitic parameters on the two sides of the first clock pair signal traces. Therefore, length changes of the first clock pair signal traces almost do not affect the EMI suppression effect. Therefore, the layout solution for data transmission trace in this application can significantly reduce EMI caused by an increase in differential-to-common mode conversion when the first clock pair signal traces are relatively long. In addition, costs of forming the first matching trace are very low, and signal quality and interconnection compatibility with another device are not affected.

In a possible implementation, the first matching trace further includes an avoidance segment, the avoidance segment is connected to the matching segment, and a third inter-pair trace spacing between the avoidance segment and the second clock signal trace is greater than or less than the first inter-pair trace spacing. In addition to the matching segment, the first matching trace further includes the avoidance segment, so that the layout solution for data transmission trace provided in this embodiment of this application is applicable to any routing scenario. There is no requirement for a layout of components such as a device and a pin in an application scenario, and positions of the device and the pin may be avoided by using the avoidance segment, so that an application scope may be expanded.

In a possible implementation, the layout solution for data transmission trace further includes a second matching trace, and the second matching trace is located on a side that is of the first matching trace and that is away from the second clock signal trace. The second matching trace is disposed on a side that is of the second clock signal trace and that is away from the first clock signal trace, so that a parasitic parameter on the side that is of the second clock signal trace and that is away from the first clock signal trace may be adjusted, and consistency between parasitic parameters on the two sides of the first clock pair signal traces may be further improved, to further reduce differential-to-common mode conversion in the first clock pair signal traces, and improve an EMI suppression effect.

In a possible implementation, a first intra-pair trace spacing between the matching segment and the second matching trace is equal to a second intra-pair trace spacing between the first data signal trace and the second data signal trace. The first intra-pair trace spacing is enabled to be equal to the second intra-pair trace spacing, so that consistency between parasitic parameters on the two sides of the first clock pair signal traces may be further improved, to further reduce differential-to-common mode conversion in the first clock pair signal traces, and improve an EMI suppression effect.

In a possible implementation, a trace width of the matching segment is equal to a trace width of the second data signal trace. The trace segment of the matching segment is set to be equal to the trace width of the second data signal trace, so that consistency between parasitic parameters on the two sides of the first clock pair signal traces may be improved, to further reduce differential-to-common mode conversion in the first clock pair signal traces, and improve an EMI suppression effect.

In a possible implementation, the first clock signal trace, the second clock signal trace, the first data signal trace, the second data signal trace, and the first matching trace have an arc corner. Arc trace is used at bends of the first clock signal trace and the second clock signal trace, and bending through arc trace does not increase a trace width at a corner, so that a width of arc trace at a bending position is equal to or approximately equal to a width of trace at a non-bending position. As a result, impedance at various positions of the first clock signal trace and the second clock signal trace is equal. In this way, signal reflection caused by an impedance change may be reduced, thereby further reducing differential-to-common mode conversion and reducing EMI.

In a possible implementation, an arc angle of the first clock signal trace, the second clock signal trace, the first data signal trace, the second data signal trace, and the first matching trace is a concentric arc angle. An arc corner θ of the first clock signal trace 21, the second clock signal trace 22, the first data signal trace 31, the second data signal trace 32, and the first matching trace 41 is a concentric arc angle θ, so that at the corner, the first inter-pair trace spacing S1 is also equal to the second inter-pair trace spacing S2, thereby further improving consistency between parasitic parameters on the two sides of the first clock pair signal traces 20.

In a possible implementation, two ends of the first matching trace are aligned with two ends of the second data signal trace. In this way, symmetry between the first matching trace and the second data signal trace on the two sides of the first clock pair signal traces may be further improved, to improve consistency between parasitic parameters on the two sides of the first clock pair signal traces, thereby further reducing differential-to-common mode conversion in the first clock pair signal traces, and improving an EMI suppression effect.

In a possible implementation, at least one end of the first matching trace is coupled to a reference ground voltage terminal.

In a possible implementation, a passive device is coupled between at least one end of the first matching trace and the reference ground voltage terminal. At least one end of the first matching trace is coupled to the passive device, and the passive device may be adjusted to further improve symmetry between the first matching trace and the second data signal trace on the two sides of the first clock pair signal traces, to improve consistency between parasitic parameters on the two sides of the first clock pair signal traces, thereby further reducing differential-to-common mode conversion in the first clock pair signal traces, and improving an EMI suppression effect.

In a possible implementation, the passive device includes at least one of a resistor, a capacitor, an inductor, or a ferrite bead. This is an implementation with a simple structure.

In a possible implementation, the first matching trace and the second matching trace form a group of second data pair signal traces, configured to transmit a data signal; and the layout solution for data transmission trace further includes second clock pair signal traces, and the second clock pair signal traces are disposed on a side that is of the second matching trace and that is away from the first matching trace. In this way, for a product with a plurality of HDMI interfaces, a layout of signal traces coupled to different HDMI connectors is adjusted, so that existing second data pair signal traces may be used as the first matching trace and the second matching trace in the layout solution provided in this embodiment of this application, thereby reducing EMI without increasing a quantity of traces.

In a possible implementation, the first matching trace is configured to transmit a low-speed signal. In this way, a layout of signal traces coupled to the HDMI connector is adjusted, so that an existing two-wire serial bus may be used as the first matching trace and the second matching trace in the layout solution provided in this embodiment of this application, thereby reducing EMI without increasing a quantity of traces.

In a possible implementation, the layout solution for data transmission trace includes a plurality of pairs of first data pair signal traces, and the plurality of pairs of first data pair signal traces are located on a same side of the first clock pair signal traces. For a structure with a plurality of pairs of data pair signal traces, the layout solution in this application may also be used to perform EMI suppression.

In a possible implementation, both the first clock pair signal traces and the first data pair signal traces are configured to be coupled between a processor and an output transmission interface connector. This is a possible application manner.

In a possible implementation, both the first clock pair signal traces and the first data pair signal traces are configured to be coupled to a high definition multimedia interface connector. This is a possible application manner.

In a possible implementation, lengths of the first clock pair signal traces are greater than 10 cm. When the lengths of the first clock pair signal traces are approximately 10 cm, EMI intensity decreases (for example, the EMI intensity decreases by 5 dB on average) in the layout solution for data transmission trace provided in this embodiment of this application, and costs are relatively low.

According to a second aspect of embodiments of this application, a mainboard is provided, including a circuit board, a processor, and an output transmission interface connector. The circuit board includes data transmission trace, the data transmission trace is routed by using the layout solution for data transmission trace according to any one of the first aspect, and both first clock pair signal traces and first data pair signal traces in the data transmission trace are coupled between the processor and the output transmission interface connector.

The mainboard provided in this embodiment of this application includes the layout solution for data transmission trace according to the first aspect, and beneficial effects of the mainboard are the same as beneficial effects of the layout solution for data transmission trace according to the first aspect. Details are not described herein again.

According to a third aspect of embodiments of this application, an electronic device is provided, including a shielding enclosure and a mainboard. The mainboard is located in the shielding enclosure, and the mainboard is the mainboard according to the second aspect.

The electronic device provided in this embodiment of this application includes the mainboard according to the second aspect, and beneficial effects of the electronic device are the same as beneficial effects of the mainboard according to the second aspect. Details are not described herein again.

### BRIEF DESCRIPTION OF DRAWINGS

FIG. 1A is a diagram of an application scenario of an electronic device according to an embodiment of this application;
FIG. 1B is a diagram of a framework of an electronic device according to an embodiment of this application;
FIG. 1C is a diagram of a structure of a mainboard in an electronic device according to an embodiment of this application;
FIG. 1D is a diagram of a structure of an HDMI connector according to an embodiment of this application;
FIG. 1E is a layout diagram of trace between an HDMI connector and a processor according to an embodiment of this application;
FIG. 2 is a diagram of a layout manner of data pair signal traces and clock pair signal traces according to an embodiment of this application;
FIG. 3 is a diagram of a layout manner of data transmission trace according to an embodiment of this application;
FIG. 4 is a diagram of another layout manner of data transmission trace according to an embodiment of this application;
FIG. 5 is a diagram of still another layout manner of data transmission trace according to an embodiment of this application;
FIG. 6 is a diagram of still another layout manner of data transmission trace according to an embodiment of this application;
FIG. 7 is a diagram of still another layout manner of data transmission trace according to an embodiment of this application;
FIG. 8 is a diagram of still another layout manner of data transmission trace according to an embodiment of this application; and
FIG. 9 is a diagram of still another layout manner of data transmission trace according to an embodiment of this application.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms such as "first" and "second" below are only for ease of description, and cannot be understood as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more.

In addition, in embodiments of this application, orientation terms such as "up", "down", "left", and "right" may include but are not limited to definitions based on illustrated orientations in which components in the accompanying drawings are placed. It should be understood that these directional terms may be relative concepts, are used for relative description and clarification, and may correspondingly change based on changes in the orientations in which the components in the accompanying drawings are placed in the accompanying drawings.

In embodiments of this application, unless otherwise clearly specified and limited, the term "connection" should be understood in a broad sense. For example, the "connection" may be a fixed connection, a detachable connection, or an integrated connection, or may be a direct connection or an indirect connection through an intermediate medium. In addition, the term "coupling" may be a direct electrical connection or an indirect electrical connection through an intermediate medium. The term "contact" may be direct contact or indirect contact through an intermediate medium.

In embodiments of this application, the term "and/or" describes an association relationship between associated objects and indicates that three relationships may exist. For example, A and/or B may indicate the following cases: Only A exists, both A and B exist, and only B exists, where A and B may be singular or plural. The character "/" generally indicates an "or" relationship between the associated objects.

An embodiment of this application provides an electronic device. The electronic device has an audio/video transmission function. For example, the electronic device may include back-end products such as a network video recorder (network video recorder, NVR), a digital video recorder (Digital video recorder, DVR), an extended video recorder (XVR), an encoder (DVS), an all-in-one computer, an industrial computer, a gateway, and an industry host. The electronic device may alternatively be an electronic device that has an audio/video transmission requirement, such as a set-top box.

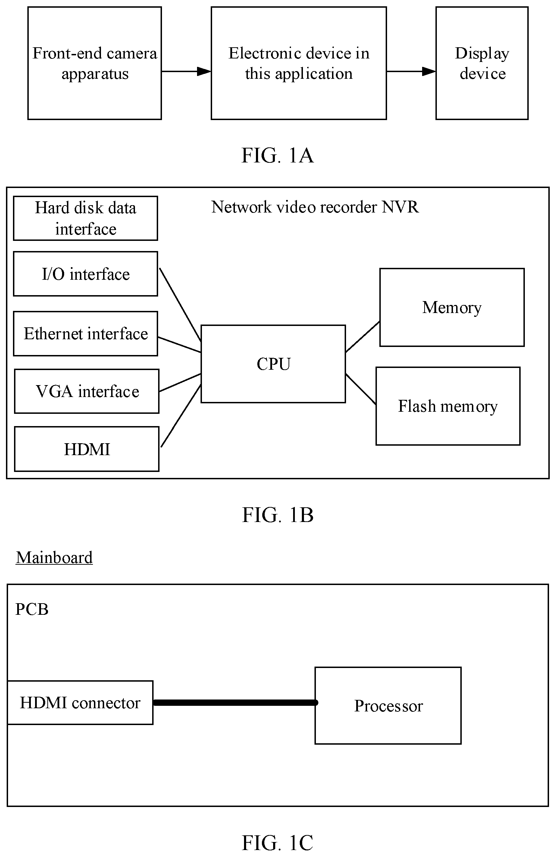

For example, as shown in FIG. 1A, a front-end camera apparatus transmits collected information such as an image and audio to the electronic device, and the electronic device transmits a plurality of groups of pictures to a display device for displaying. For example, the display device may simultaneously display 9-grid or 12-grid surveillance pictures.

For example, as shown in FIG. 1B, a network video recorder NVR is illustrated. The network video recorder NVR includes a processor, and the processor may be, for example, a central processing unit (central processing unit, CPU). The network video recorder NVR further includes a memory, a flash memory (flash), a hard disk data interface, an input/output (I/O) interface, an Ethernet interface, a video graphics array (video graphics array, VGA) interface, and a high definition multimedia interface (high definition multimedia interface, HDMI) that are coupled to the central processing unit CPU.

The processor, the memory, the flash memory (flash), the hard disk data interface, the input/output (I/O) interface, the Ethernet interface, and the high definition multimedia interface HDMI may be, for example, disposed on a printed circuit board (printed circuit board, PCB), which is used as a mainboard of the network video recorder NVR.

The network video recorder NVR may further include a shielding enclosure, and the mainboard is disposed in the shielding enclosure. For example, the shielding enclosure may shield electromagnetic interference (electromagnetic interference, EMI), and a material of the shielding enclosure may be, for example, metal.

For example, the central processing unit CPU is configured to process services of the network video recorder NVR, such as compression coding of video data and data receiving and sending; the memory is configured to provide temporary data storage space required when the central processing unit CPU runs; the flash memory is configured to provide permanent storage space for storing firmware and system configuration information of the network video recorder NVR; the hard disk data interface is configured to connect to a hard disk and transmit video data to the hard disk for storage; the input/output interface is configured to provide input/output triggered by I/O; the Ethernet interface is configured to connect to the Ethernet; the VGA interface is configured to connect to a VGA display, and a video image is displayed through the VGA display; and the high definition multimedia interface HDMI is configured to connect to a display device, and a video image is displayed through the display device.

A high definition multimedia interface connector at the high definition multimedia interface HDMI is coupled to the processor by using clock pair signal traces and data pair signal traces.

For example, as shown in FIG. 1C, a mainboard of the electronic device includes a PCB, a data transmission port connector, and a processor. The data transmission port connector and the processor are disposed on the PCB.

The data transmission port connector is, for example, an HDMI connector, a mobile industry processor interface (mobile industry processor interface, MIPI) connector, or the like. A data transmission interface may be configured to transmit data signals such as audio, video, and file signals.

FIG. 1C illustrates an example of the data transmission port connector being an HDMI connector. The HDMI connector is coupled to the processor through a trace, to complete signal transmission. The trace coupled between the HDMI connector and the processor may be integrated on the PCB.

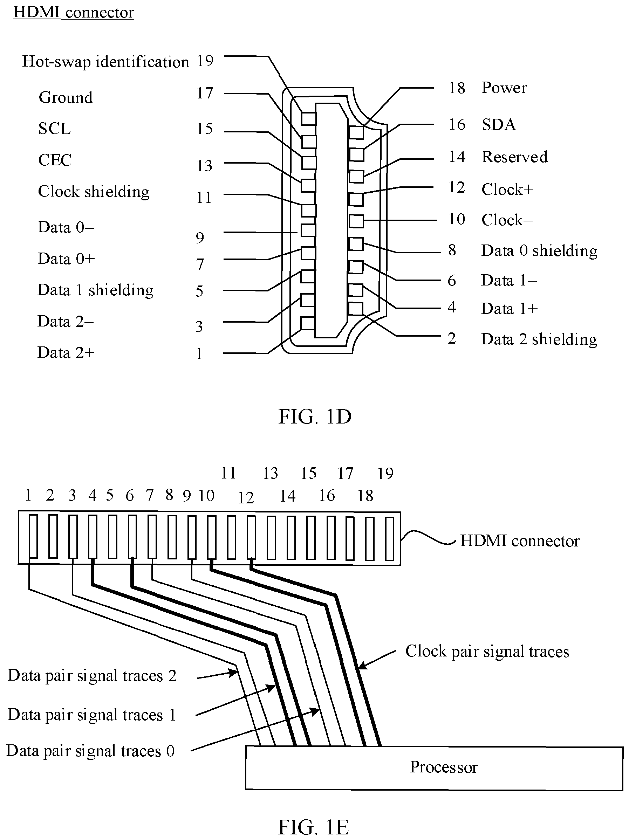

For example, the HDMI connector has a plurality of terminals. FIG. 1D illustrates an example of the HDMI connector having 19 terminals.

A terminal 1 and a terminal 3 are configured to transmit data pair signals (data 2+ and data 2-), and a terminal 2 is configured to be coupled to a shield layer of a data pair. A terminal 4 and a terminal 6 are configured to transmit data pair signals (data 1+ and data 1-), and a terminal 5 is configured to be coupled to a shield layer of a data pair. A terminal 7 and a terminal 9 are configured to transmit data pair signals (data 0+ and data 0-), and a terminal 8 is configured to be coupled to a shield layer of a data pair. A terminal 10 and a terminal 12 are configured to transmit clock pair signals (clock+ and clock-), and a terminal 11 is configured to be coupled to a shield layer of a clock pair. A terminal 13 is used as a controller terminal CEC. A terminal 14 is reserved. A terminal 15 and a terminal 16 are used as connection terminals of a two-wire serial bus (inter-integrated circuit, I2C), the terminal 15 is used as a bidirectional data line terminal SDA of the two-wire serial bus, and the terminal 16 is used as a clock line terminal SCL of the two-wire serial bus. A terminal 17 is used as a ground terminal. A terminal 18 is used as a power terminal. A terminal 19 is used as a hot-swap identification terminal.

Each terminal is separately coupled to the trace, but only some terminals are coupled to the processor through the trace.

For example, as shown in FIG. 1E, the terminal 7 and the terminal 9 are coupled to the processor by using data pair signal traces 0, the terminal 4 and the terminal 6 are coupled to the processor by using data pair signal traces 1, the terminal 1 and the terminal 3 are coupled to the processor by using data pair signal traces 2, and the terminal 10 and the terminal 12 are coupled to the processor by using clock pair signal traces. The terminal 2, the terminal 5, the terminal 8, and the terminal 1 are used as shielded terminals, and are coupled to shielded traces, and the shielded traces are not coupled to the processor.

In the terminal 1 to the terminal 19 in the HDMI connector, the terminal 1, the terminal 3, the terminal 4, the terminal 6, the terminal 7, the terminal 9, the terminal 10, and the terminal 12 are coupled to the processor through a trace.

Although a data transmission interface with a clock pair and a data pair may enable the electronic device to have a relatively high signal transmission rate, clock pair signals are usually prone to generating electromagnetic interference (electromagnetic interference, EMI) in a transmission process.

Positions at which the clock pair signals generate electromagnetic interference may be divided into two parts: One part is the PCB that is inside the electronic device and from which electromagnetic interference is emitted, and the other part is a connection trace that is outside the electronic device and from which electromagnetic interference is emitted.

A main cause of overrun electromagnetic interference is that a trace layout of the clock pair on the PCB is asymmetric. As a result, differential-to-common mode conversion of a clock signal is performed, and a common-mode signal is generated. The common-mode signal has a large interference amplitude and a high frequency, and may further generate radiation through a trace, resulting in relatively large electromagnetic interference. Because a trace length of the clock pair on the PCB is usually much shorter than a length of a trace outside the electronic device, and the PCB is usually constrained in a metal shielding enclosure, electromagnetic interference generated by the common-mode signal on the PCB is not a main cause of overrun electromagnetic interference. Electromagnetic interference that is generated by the electronic device and that is brought out of the electronic device by the common-mode signal through the trace outside the electronic device is the main cause of overrun electromagnetic interference. However, an essential cause of overrun electromagnetic interference is that the trace layout of the clock pair on the PCB is asymmetric.

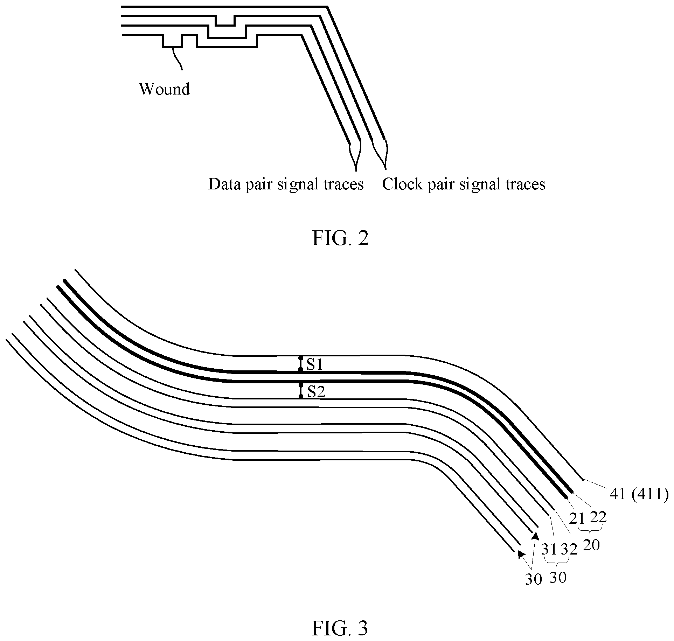

In some technologies, as shown in FIG. 2, the PCB includes clock pair signal traces and data pair signal traces, and the clock pair signal traces and the data pair signal traces are configured to transmit signals such as audio, video, and document signals. Wound parts are disposed on the clock pair signal traces and the clock pair signal traces, so that the clock pair signal traces have an equal intra-pair length, and the data pair signal traces and the clock pair signal traces have an equal length or approximately equal lengths.

A wound serpentine trace maintains the equal intra-pair length of the clock pair signal traces, so that two signals with opposite polarities in the clock pair may arrive at the same time, thereby reducing generation of a common-mode signal and reducing EMI.

Symmetry of the trace layout of the clock pair may be improved by the wound serpentine trace by maintaining the equal intra-pair length of the clock pair signal traces, but the data pair signal traces are always located on one side of the clock pair signal traces. Therefore, even if the clock pair signal traces have the equal intra-pair length, parasitic capacitance and the like may exist on two sides of the clock pair signal traces. As a result, when the trace is relatively long (for example, trace of the high definition multimedia interface HDMI exceeds 10 cm), significant differential-to-common mode conversion is also caused due to accumulation of small asymmetry of an ambient environment of the clock pair signal traces, thereby causing an EMI problem.

In some other technologies, EMI is reduced by adjusting a related parameter of the mainboard.

For example, a driving capability of an output pin of the mainboard is reduced, and a clock spread spectrum is used. Reducing the driving capability of the mainboard may slow down a rising edge of a square wave signal and reduce a high-frequency component of the signal, thereby reducing EMI. The clock spread spectrum is used to enable a clock frequency to jitter within a frequency range centered on a working frequency, thereby reducing radiation energy concentrated on the working frequency and a multiplied-frequency of the working frequency, and reducing EMI at the frequency.

Reducing the driving capability of the mainboard and using the clock spread spectrum can reduce EMI, but also reduce signal quality and interconnection compatibility with another device.

In still other technologies, EMI is reduced by adding a component or a material that suppresses radiation.

For example, a common-mode rejection inductor and a trace with a better shielding effect are used. The common-mode rejection inductor can convert a common-mode signal generated due to asymmetry of trace on the PCB into heat to be dissipated, thereby reducing a common-mode signal transmitted to an external trace and reducing EMI. The trace with a better shielding effect can effectively prevent EMI leakage, thereby reducing EMI.

The common-mode rejection inductor and the trace with a better shielding effect can reduce EMI, but also increase costs.

In view of this, an embodiment of this application provides a layout solution for data transmission trace, to reduce, by adjusting a layout of trace, EMI caused by clock pair signal traces.

As shown in FIG. 3, the data transmission trace includes first clock pair signal traces 20, first data pair signal traces 30, and a first matching trace 41.

The first clock pair signal traces 20 include a first clock signal trace 21 and a second clock signal trace 22, and the first clock pair signal traces 20 are configured to transmit a clock signal.

The first data pair signal traces 30 include a first data signal trace 31 and a second data signal trace 32, and the first data pair signal traces 30 are configured to transmit a data signal.

Certainly, the data transmission trace may include one pair of first data pair signal traces 30, and the data transmission trace may alternatively include a plurality of pairs of first data pair signal traces 30. When the data transmission trace includes a plurality of pairs of first data pair signal traces 30, the plurality of pairs of first data pair signal traces 30 are located on a same side of the first clock pair signal traces 20. FIG. 3 illustrates an example of the data transmission trace including a plurality of pairs of first data pair signal traces 30.

In some embodiments, both the first clock pair signal traces 20 and the first data pair signal traces 30 are configured to be coupled to an HDMI connector.

For example, the first clock pair signal traces 20 are used as the clock pair signal traces in FIG. 1E, and are coupled between a terminal 10 and a terminal 12 in the HDMI connector and a processor.

The plurality of pairs of first data pair signal traces 30 are three pairs of first data pair signal traces 30. One pair of first data pair signal traces 30 are used as the data pair signal traces 2 in FIG. 1E, and are coupled between a terminal 1 and a terminal 3 in the HDMI connector and the processor. One pair of first data pair signal traces 30 are used as the data pair signal traces 1 in FIG. 1E, and are coupled between a terminal 4 and a terminal 6 in the HDMI connector and the processor. One pair of first data pair signal traces 30 are used as the data pair signal traces 0 in FIG. 1E, and are coupled between a terminal 7 and a terminal 9 in the HDMI connector and the processor.

The first matching trace 41 is configured to adjust a parasitic parameter around the first clock pair signal traces 20.

In this embodiment of this application, the first matching trace 41 may be coupled to the HDMI connector, or the first matching trace 41 may not be coupled to the HDMI connector.

The layout solution for data transmission trace includes that the first matching trace 41 and the first data pair signal traces 30 are located on two opposite sides of the first clock pair signal traces 20, or it is understood that the first clock pair signal traces 20 are located between the first matching trace 41 and the first data pair signal traces 30.

For example, as shown in FIG. 3, along an arrangement direction of the data transmission trace, the first data signal trace 31, the second data signal trace 32, the first data signal trace 31, the second data signal trace 32, the first data signal trace 31, the second data signal trace 32, the first clock signal trace 21, the second clock signal trace 22, and the first matching trace 41 are sequentially arranged.

In this case, the first clock signal trace 21 and the second data signal trace 32 are disposed adjacent to each other, and the second clock signal trace 22 and the first matching trace 41 are disposed adjacent to each other.

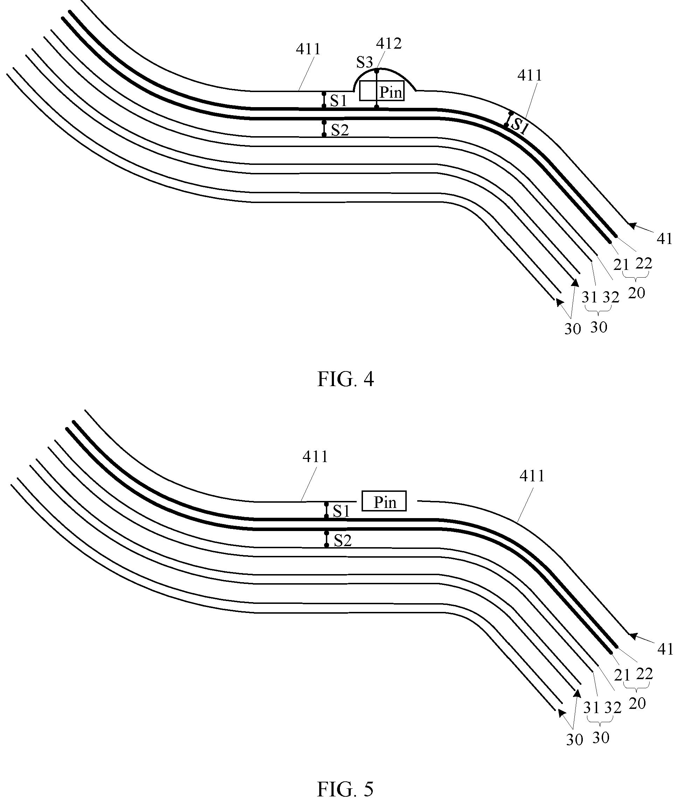

In some embodiments, as shown in FIG. 4, the first matching trace 41 includes a matching segment 411 and an avoidance segment 412, and the avoidance segment 412 is connected to the matching segment 411.

It is explained herein that a position at which the avoidance segment 412 appears in the first matching trace 41, a quantity of times that the avoidance segment 412 appears, and a shape of the avoidance segment 412 depend on a layout of a device and a pin around the data transmission trace. The avoidance segment 412 is configured to avoid components such as the device and the pin in an extension process of the first matching trace 41.

In addition to the matching segment 411, the first matching trace 41 further includes the avoidance segment 412, so that the layout solution for data transmission trace provided in this embodiment of this application is applicable to any routing scenario. There is no requirement for a layout of components such as a device and a pin in an application scenario, and positions of the device and the pin may be avoided by using the avoidance segment 412, so that an application scope may be expanded.

In some embodiments, as shown in FIG. 4, there is a first inter-pair trace spacing S1 between the matching segment 411 and the second clock signal trace 22, there is a third inter-pair trace spacing S3 between the avoidance segment 412 and the second clock signal trace 22, and there is a second inter-pair trace spacing S2 between the second data signal trace 32 and the first clock signal trace 21.

The first inter-pair trace spacing S1 is equal to the second inter-pair trace spacing S2, and the first inter-pair trace spacing S1 is not equal to the third inter-pair trace spacing S3. When there are a plurality of different third inter-pair trace spacings S3 between each position of the avoidance segment 412 and the second clock signal trace 22, each third inter-pair trace spacing S3 is not equal to the first inter-pair trace spacing S1, and the plurality of different third inter-pair trace spacings S3 may be equal or may not be equal.

In this embodiment of this application, equality is not absolute equality, and approximate equality also belongs to equality in this embodiment of this application. For example, in this embodiment of this application, process errors of widths of the first data signal trace 31, the second data signal trace 32, the first clock signal trace 21, the second clock signal trace 22, and the first matching trace 41 are ±30%. In this case, a difference between the second inter-pair trace spacing S2 and the first inter-pair trace spacing S1 being ±60% of the first inter-pair trace spacing S1 also belongs to equality between the first inter-pair trace spacing S1 and the second inter-pair trace spacing S2 in this embodiment of this application.

Certainly, the first inter-pair trace spacing S1 may be greater than the third inter-pair trace spacing S3, and the first inter-pair trace spacing S1 may alternatively be less than the third inter-pair trace spacing S3. FIG. 4 is only an example.

In some other embodiments, the first matching trace 41 includes only the matching segment 411.

For example, as shown in FIG. 3, the first matching trace 41 includes one matching segment 411.

There is a first inter-pair trace spacing S1 between the matching segment 411 and the second clock signal trace 22, there is a second inter-pair trace spacing S2 between the second data signal trace 32 and the first clock signal trace 21, and the first inter-pair trace spacing S1 is equal to the second inter-pair trace spacing S2.

In this way, the first matching trace 41 and the second data signal trace 32 may be symmetrically disposed on two sides of the first clock pair signal traces 20. Higher symmetry of signal traces on the two sides of the first clock pair signal traces 20 leads to higher consistency between parasitic parameters on the two sides of the first clock pair signal traces 20, a better suppression effect on differential-to-common mode conversion, and a better EMI reduction effect.

Alternatively, for example, as shown in FIG. 5, the first matching trace 41 includes a plurality of matching segments 411 spaced apart.

In this case, when encountering components such as a device and a pin in an extension process of the first matching trace 41, the first matching trace 41 is disconnected to skip the components such as the device and the pin, to avoid the components such as the device and the pin.

There is a first inter-pair trace spacing S1 between each matching segment 411 and the second clock signal trace 22, there is a second inter-pair trace spacing S2 between the second data signal trace 32 and the first clock signal trace 21, and each first inter-pair trace spacing S1 is equal to the second inter-pair trace spacing S2.

In this way, the layout solution for data transmission trace provided in this embodiment of this application is applicable to any routing scenario, and a layout of the first matching trace 41 may be simplified.

In the layout solution for data transmission trace provided in this embodiment of this application, the first data pair signal traces 30 are arranged on a first side of the first clock pair signal traces 20, and the first matching trace 41 is arranged on an opposite second side of the first clock pair signal traces 20. Presence of the first matching trace 41 may change a parasitic parameter (for example, a value of parasitic capacitance) on the second side of the first clock pair signal traces 20. The first inter-pair trace spacing S1 between the matching segment 411 and the second clock signal trace 22 is enabled to be equal to the second inter-pair trace spacing S2 between the second data signal trace 32 and the first clock signal trace 21, so that consistency between parasitic parameters on the two sides of the first clock pair signal traces 20 may be improved, to reduce differential-to-common mode conversion in the first clock pair signal traces 20, and improve an EMI suppression effect.

In addition, in this embodiment of this application, EMI is reduced by improving the consistency between the parasitic parameters on the two sides of the first clock pair signal traces 20. Therefore, length changes of the first clock pair signal traces 20 almost do not affect EMI suppression. Therefore, the layout solution for data transmission trace in this application can significantly reduce EMI caused by an increase in differential-to-common mode conversion when the first clock pair signal traces 20 are relatively long. In addition, costs of forming the first matching trace 41 are low, and signal quality and interconnection compatibility with another device are not affected.

In some embodiments, lengths (sizes in an extension direction) of the first clock pair signal traces 20 are greater than 10 cm.

According to an actual test, when the lengths of the first clock pair signal traces 20 are approximately 10 cm, EMI intensity decreases (for example, the EMI intensity decreases by 5 dB on average) in the layout solution for data transmission trace provided in this embodiment of this application, compared with the layout solution shown in FIG. 2. Compared with the solution of using a trace with a better shielding effect, the layout solution for data transmission trace may reduce costs.

In some embodiments, trace widths of the first data signal trace 31, the second data signal trace 32, the first clock signal trace 21, and the second clock signal trace 22 are equal.

It may be understood that, in an extension process of the trace, if there is a bend in the trace, a trace width at a curve is increased when the bend is the curve. Therefore, in this embodiment of this application, a trace width of the trace is a trace width at a non-bending position.

It should be noted that, in the accompanying drawing provided in this embodiment of this application, the first clock pair signal traces 20 are bold lines compared with the first data pair signal traces 30. This is merely for ease of determining positions of the first clock signal traces 20 in the layout solution, and does not indicate that the first clock pair signal traces 20 are wider than the first data pair signal traces 30.

In some embodiments, a trace width of the matching segment 411 in the first matching trace 41 is equal to a trace width of the second data signal trace 32.

In this embodiment of this application, equality is not absolute equality, and approximate equality also belongs to equality in this embodiment of this application. For example, in this embodiment of this application, process errors of widths of the first data signal trace 31, the second data signal trace 32, the first clock signal trace 21, the second clock signal trace 22, and the first matching trace 41 are ±30%. In this case, a difference between the widths of the first data signal trace 31, the second data signal trace 32, the first clock signal trace 21, the second clock signal trace 22, and the first matching trace 41 being ±60% of the width of the second data signal trace 32 also belongs to trace width equality in this embodiment of this application.

When the first matching trace 41 further includes the avoidance segment 412, a trace width of the avoidance segment 412 may be equal to or not equal to the trace width of the second data signal trace 32.

The trace segment of the matching segment 411 is set to be equal to the trace width of the second data signal trace 32, so that consistency between parasitic parameters on the two sides of the first clock pair signal traces 20 may be improved, to further reduce differential-to-common mode conversion in the first clock pair signal traces 20, and improve an EMI suppression effect.

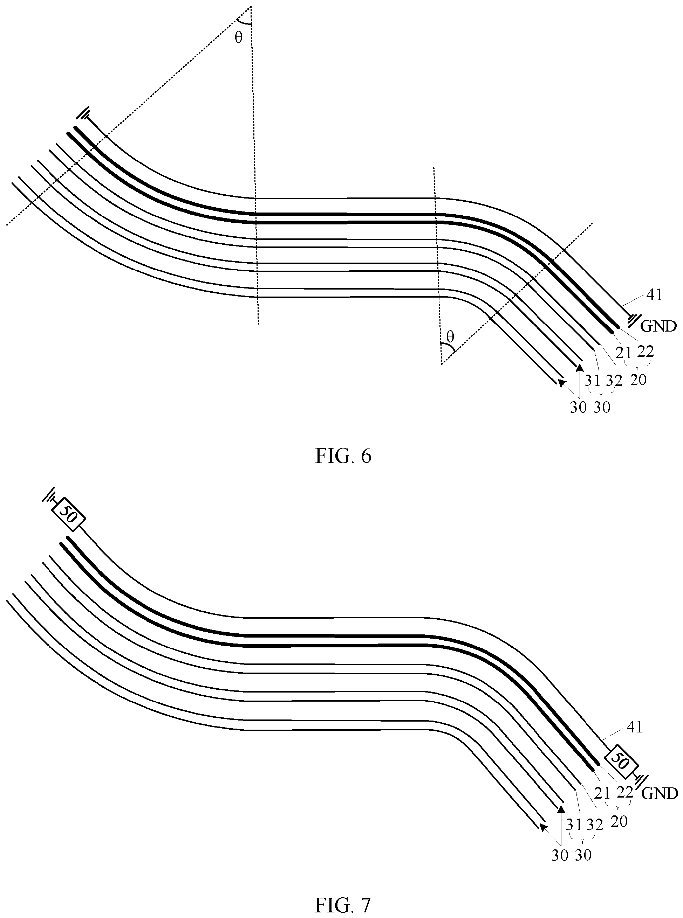

In some embodiments, as shown in FIG. 6, the first clock signal trace 21 and the second clock signal trace 22 have an arc corner θ.

In some embodiments, the first clock signal trace 21, the second clock signal trace 22, the first data signal trace 31, the second data signal trace 32, and the first matching trace 41 have a concentric arc corner θ.

That is, at a bending position of the trace, arc trace is used for bending transition. At a same bending position, an arc corner θ of the first clock signal trace 21, the second clock signal trace 22, the first data signal trace 31, the second data signal trace 32, and the first matching trace 41 is a concentric arc corner.

The first clock signal trace 21 is used as an example. In an extension track of the first clock signal trace 21, the first clock signal trace 21 may have one or more bends, and an arc bend may be used at a bending position of the first clock signal trace 21. When there are a plurality of bends in the extension track of the first clock signal trace 21, sizes of arc corners θ at a plurality of bending positions may be equal, or sizes of arc corners θ at a plurality of bending positions may not be equal. This may be properly set as required.

Arc trace is used at bends of the first clock signal trace 21 and the second clock signal trace 22, and bending through arc trace does not increase a trace width at a corner, so that a width of arc trace at a bending position is equal to or approximately equal to a width of trace at a non-bending position. As a result, impedance at various positions of the first clock signal trace 21 and the second clock signal trace 22 is equal. In this way, signal reflection caused by an impedance change may be reduced, thereby further reducing differential-to-common mode conversion and reducing EMI.

An arc corner θ of the first clock signal trace 21, the second clock signal trace 22, the first data signal trace 31, the second data signal trace 32, and the first matching trace 41 is a concentric arc angle θ, so that at the corner, the first inter-pair trace spacing S1 is also equal to the second inter-pair trace spacing S2, thereby further improving consistency between parasitic parameters on the two sides of the first clock pair signal traces 20.

Certainly, at a bending position of the trace, curve trace may alternatively be used for bending transition. This is not limited in this embodiment of this application. For example, when a curve trace is used for bending transition at a bending position of the trace, at a same bending position, the first clock signal trace 21, the second clock signal trace 22, the first data signal trace 31, the second data signal trace 32, and the first matching trace 41 are bent at an equal curve angle.

In some embodiments, along an extension direction of the trace, two ends of the first matching trace 41 are aligned with two ends of the second data signal trace 32.

Alternatively, it is understood that a connection line between a first end of the first matching trace 41 and a first end of the second data signal trace 32 is perpendicular to the first matching trace 41 and the second data signal trace 32, and a connection line between a second end of the first matching trace 41 and a second end of the second data signal trace 32 is perpendicular to the first matching trace 41 and the second data signal trace 32.

In this way, symmetry between the first matching trace 41 and the second data signal trace 32 on the two sides of the first clock pair signal traces 20 may be further improved, to improve consistency between parasitic parameters on the two sides of the first clock pair signal traces 20, thereby further reducing differential-to-common mode conversion in the first clock pair signal traces 20, and improving an EMI suppression effect.

In some embodiments, as shown in FIG. 6, at least one end of the first matching trace 41 is coupled to a reference ground voltage terminal GND. FIG. 6 illustrates an example in which two ends of the first matching trace 41 are coupled to reference ground voltage terminals GND.

At least one end of the first matching trace 41 is coupled to a reference ground voltage terminal GND, so that the first matching trace 41 is used for shielding, in addition to adjusting a parasitic parameter.

In some embodiments, as shown in FIG. 7, a passive device 50 is coupled between at least one end of the first matching trace 41 and the reference ground voltage terminal GND. FIG. 7 illustrates an example in which two ends of the first matching trace 41 are coupled to passive devices 50.

The passive device 50 may include, for example, at least one of a resistor, a capacitor, an inductor, or a ferrite bead. The passive devices 50 at the two ends of the first matching trace 41 may be the same, or the passive devices 50 at the two ends of the first matching trace 41 may be different.

At least one end of the first matching trace 41 is coupled to the passive device 50, and the passive device 50 may be adjusted to further improve symmetry between the first matching trace 41 and the second data signal trace 32 on the two sides of the first clock pair signal traces 20, to improve consistency between parasitic parameters on the two sides of the first clock pair signal traces 20, thereby further reducing differential-to-common mode conversion in the first clock pair signal traces 20, and improving an EMI suppression effect.

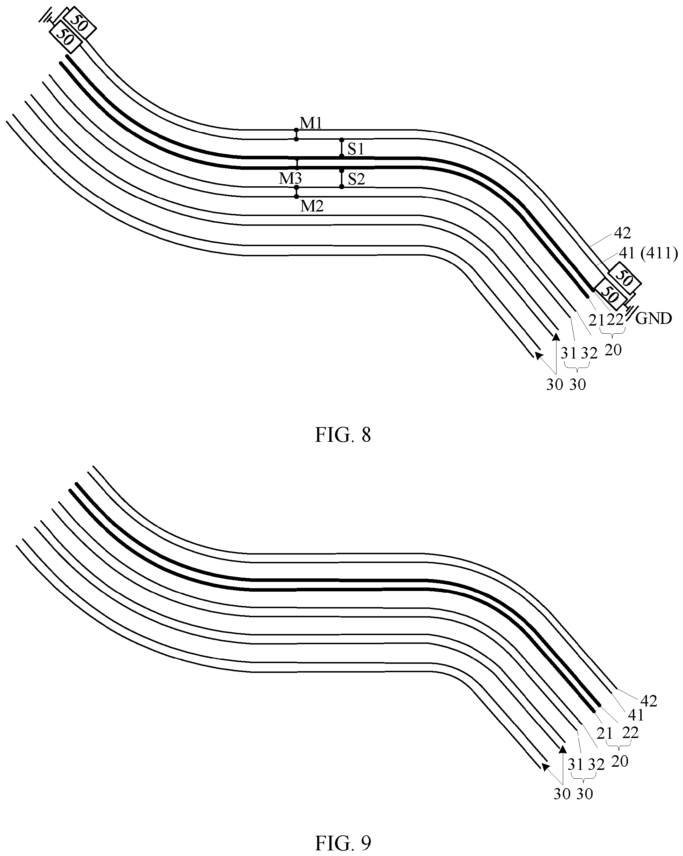

In some embodiments, as shown in FIG. 8, the layout solution for data transmission trace further includes a second matching trace 42, and the second matching trace 42 is located on a side that is of the first matching trace 41 and that is away from the second clock signal trace 22.

Alternatively, it is understood that the first matching trace 41 is located between the second matching trace 42 and the second clock signal trace 22.

For a structure of the second matching trace 42, refer to the foregoing related description of the structure of the first matching trace 41.

The second matching trace 42 may include only a matching segment, or the second matching trace 42 may include a matching segment and an avoidance segment. The first matching trace 41 and the second matching trace 42 may have a same structure, or the first matching trace 41 and the second matching trace 42 may have different structures. This is not limited in this embodiment of this application.

Two ends of the second matching trace 42 may be coupled to reference ground voltage terminals GND, or two ends of the second matching trace 42 may not be coupled to reference ground voltage terminals GND.

The two ends of the second matching trace 42 may be coupled to passive devices 50, or the two ends of the second matching trace 42 may not be coupled to passive devices 50.

In some embodiments, a width of the second matching trace 42 is equal to a width of the first matching trace 41.

In this embodiment of this application, equality is not absolute equality, and approximate equality also belongs to equality in this embodiment of this application. For example, in this embodiment of this application, process errors of widths of the second matching trace 42 and the first matching trace 41 are ±30%. In this case, a difference between the widths of the second matching trace 42 and the first matching trace 41 being ±60% of the width of the first matching trace 41 also belongs to equality between the widths of the second matching trace 42 and the first matching trace 41 in this embodiment of this application.

In some embodiments, the second matching trace 42 and the first matching trace 41 have a concentric arc corner θ.

Certainly, the layout solution for data transmission trace may further include a plurality of matching traces such as a third matching trace and a fourth matching trace. This is not limited in this embodiment of this application.

The second matching trace 42 or more matching traces are disposed on a side that is of the second clock signal trace 22 and that is away from the first clock signal trace 21, so that a parasitic parameter on the side that is of the second clock signal trace 22 and that is away from the first clock signal trace 21 may be adjusted, and consistency between parasitic parameters on the two sides of the first clock pair signal traces 20 may be further improved, to further reduce differential-to-common mode conversion in the first clock pair signal traces 20, and improve an EMI suppression effect.

In some embodiments, as shown in FIG. 8, a first intra-pair trace spacing M1 between the matching segment 411 and the second matching trace 42 is equal to a second intra-pair trace spacing M2 between the first data signal trace 31 and the second data signal trace 32.

In this embodiment of this application, equality is not absolute equality, and approximate equality also belongs to equality in this embodiment of this application. For example, in this embodiment of this application, process errors of widths of the first data signal trace 31, the second data signal trace 32, the first clock signal trace 21, the second clock signal trace 22, and the first matching trace 41 are ±30%. In this case, a difference between the first intra-pair trace spacing M1 and the second intra-pair trace spacing M2 being ±60% of the first intra-pair trace spacing M1 also belongs to equality between the first intra-pair trace spacing M1 and the second intra-pair trace spacing M2 in this embodiment of this application.

The first intra-pair trace spacing M1 is enabled to be equal to the second intra-pair trace spacing M2, so that consistency between parasitic parameters on the two sides of the first clock pair signal traces 20 may be further improved, to further reduce differential-to-common mode conversion in the first clock pair signal traces 20, and improve an EMI suppression effect.

In some embodiments, still refer to FIG. 8. A third intra-pair trace spacing M3 between the first clock signal trace 21 and the second clock signal trace 22, the first intra-pair trace spacing M1, and the second intra-pair trace spacing M2 are equal.

In this way, consistency between parasitic parameters on the two sides of the first clock pair signal traces 20 may be further improved, to further reduce differential-to-common mode conversion in the first clock pair signal traces 20, and improve an EMI suppression effect.

In some embodiments, as shown in FIG. 9, two ends of the first matching trace 41 and two ends of the second matching trace 42 are not coupled to reference ground voltage terminals GND.

For example, the first matching trace 41 and the second matching trace 42 form a group of second data pair signal traces, configured to transmit a data signal. The layout solution for data transmission trace further includes second clock pair signal traces, and the second clock pair signal traces are disposed on a side that is of the second matching trace 42 and that is away from the first matching trace 41.

In this case, the two ends of the first matching trace 41 and the two ends of the second matching trace 42 are not coupled to reference ground voltage terminals GND, but are coupled to an HDMI connector and the processor. Certainly, the HDMI connector coupled to the second data pair signal traces and the second clock pair signal traces and the HDMI connector coupled to the first data pair signal traces 30 and the first clock pair signal traces 20 are different HDMI connectors. An electronic device to which the layout solution provided in this embodiment of this application is applied includes a plurality of HDMI interfaces.

In this way, for a product with a plurality of HDMI interfaces, a layout of signal traces coupled to different HDMI connectors is adjusted, so that existing second data pair signal traces may be used as the first matching trace 41 and the second matching trace 42 in the layout solution provided in this embodiment of this application, thereby reducing EMI without increasing a quantity of traces.

Alternatively, for example, the first matching trace 41, the second matching trace 42, and the first clock pair signal traces 20 are coupled to the same HDMI connector. The first matching trace 41 and the second matching trace 42 form a differential pair, and are configured to transmit a low-speed signal.

The low-speed signal in this embodiment of this application is, for example, a signal whose transmission speed is less than 50 Mbit/s.

For example, the first matching trace 41 and the second matching trace 42 are used as a two-wire serial bus, are coupled to the terminal 15 and the terminal 16 in the HDMI connector shown in FIG. 1D, and are configured to transmit a low-speed signal.

In this way, a layout of signal traces coupled to the HDMI connector is adjusted, so that an existing two-wire serial bus may be used as the first matching trace 41 and the second matching trace 42 in the layout solution provided in this embodiment of this application, thereby reducing EMI without increasing a quantity of traces.

It should be noted that, in extension tracks of the first clock pair signal traces 20, the first data pair signal traces 30, the first matching trace 41, and the second matching trace 42, not the entire extension tracks are required to meet the foregoing features described in this embodiment of this application, provided that some trace segments meet the foregoing descriptions, the extension tracks fall within the protection scope of this embodiment of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A layout solution for data transmission trace, comprising:
first clock pair signal traces, comprising a first clock signal trace and a second clock signal trace, wherein the first clock pair signal traces are configured to transmit a clock signal;
first data pair signal traces, comprising a first data signal trace and a second data signal trace, wherein the first data pair signal traces are configured to transmit a data signal;
a first matching trace, wherein the first clock pair signal traces are located between the first matching trace and the first data pair signal traces;
the first clock signal trace and the second data signal trace are disposed adjacent to each other, and the second clock signal trace and the first matching trace are disposed adjacent to each other; the first matching trace comprises a matching segment, and a first inter-pair trace spacing between the matching segment and the second clock signal trace is equal to a second inter-pair trace spacing between the second data signal trace and the first clock signal trace; and
both the first clock pair signal traces and the first data pair signal traces are configured to be coupled between a processor and an output transmission interface connector.

2. The layout solution for data transmission trace according to claim 1, wherein the first matching trace further comprises an avoidance segment, the avoidance segment is connected to the matching segment, and a third inter-pair trace spacing between the avoidance segment and the second clock signal trace is greater than or less than the first inter-pair trace spacing.

3. The layout solution for data transmission trace according to claim 1 or 2, wherein the layout solution for data transmission trace further comprises a second matching trace, and the second matching trace is located on a side that is of the first matching trace and that is away from the second clock signal trace.

4. The layout solution for data transmission trace according to claim 3, wherein a first intra-pair trace spacing between the matching segment and the second matching trace is equal to a second intra-pair trace spacing between the first data signal trace and the second data signal trace.

5. The layout solution for data transmission trace according to any one of claims 1 to 4, wherein a trace width of the matching segment is equal to a trace width of the second data signal trace.

6. The layout solution for data transmission trace according to any one of claims 1 to 5, wherein the first clock signal trace, the second clock signal trace, the first data signal trace, the second data signal trace, and the first matching trace have a concentric arc corner.

7. The layout solution for data transmission trace according to any one of claims 1 to 6, wherein two ends of the first matching trace are aligned with two ends of the second data signal trace.

8. The layout solution for data transmission trace according to any one of claims 1 to 7, wherein at least one end of the first matching trace is coupled to a reference ground voltage terminal.

9. The layout solution for data transmission trace according to claim 8, wherein a passive device is coupled between at least one end of the first matching trace and the reference ground voltage terminal.

10. The layout solution for data transmission trace according to claim 9, wherein the passive device comprises at least one of a resistor, a capacitor, an inductor, or a ferrite bead.

11. The layout solution for data transmission trace according to any one of claims 3 to 7, wherein the first matching trace and the second matching trace form a group of second data pair signal traces, configured to transmit a data signal; and
the layout solution for data transmission trace further comprises second clock pair signal traces, and the second clock pair signal traces are disposed on a side that is of the second matching trace and that is away from the first matching trace.

12. The layout solution for data transmission trace according to any one of claims 1 to 7, wherein the first matching trace is configured to transmit a low-speed signal.

13. The layout solution for data transmission trace according to any one of claims 1 to 12, wherein the layout solution for data transmission trace comprises a plurality of pairs of first data pair signal traces, and the plurality of pairs of first data pair signal traces are located on a same side of the first clock pair signal traces.

14. The layout solution for data transmission trace according to any one of claims 1 to 13, wherein both the first clock pair signal traces and the first data pair signal traces are configured to be coupled to a high definition multimedia interface connector.

15. The layout solution for data transmission trace according to any one of claims 1 to 14, wherein lengths of the first clock pair signal traces are greater than 10 cm.

16. A mainboard, comprising a circuit board, a processor, and an output transmission interface connector, wherein the circuit board comprises data transmission trace, the data transmission trace is routed by using the layout solution for data transmission trace according to any one of claims 1 to 15, and both first clock pair signal traces and first data pair signal traces in the data transmission trace are coupled between the processor and the output transmission interface connector.

17. An electronic device, comprising a shielding enclosure and a mainboard, wherein the mainboard is located in the shielding enclosure, and the mainboard is the mainboard according to claim 16.
